# EUROPEAN PATENT SPECIFICATION

(11) **EP 1 519 234 B1**
(45) Date of publication and mention of the grant of the patent: **01.04.2015**
(21) Application number: 03257383.4
(22) Date of filing: 24.11.2003
(51) Int. Cl.: G03F 7/42, C11D 7/08, C11D 7/26, C11D 7/32, C11D 7/34, C11D 11/00

(54) **Stripping and cleaning compositions for microelectronics**
Entschichtungs- und Reinigungszusammensetzungen für die Mikroelektronik
Compositions de nettoyage et de décapage pour la micro-électronique

(30) Priority: 06.08.2003 US 493089 P
(43) Date of publication of application: 30.03.2005
(73) Proprietor: Avantor Performance Materials, Inc., Phillipsburg, NJ 08865 (US)
(72) Inventor: Kane, Sean Michael, Bethlehem Pennsylvania 18018 (US); Kim, Sang In, Tae-Young APT., Su-Won City Kyoung-Ki Do (KR)
(74) Representative: EP&C

(56) References cited:
- EP-A- 0 596 515
- WO-A-2004/029723
- WO-A-2004/099091
- US-A- 5 698 503
- US-A1- 2003 099 908
- US-A1- 2003 130 147
- SCHWARTZKOPF G ET AL: "DESIGN OF LOW ALKALINITY ORGANIC PHOTORESIST STRIPPERS" EXTENDED ABSTRACTS, ELECTROCHEMICAL SOCIETY. PRINCETON, NEW JERSEY, US, vol. 93/1, January 1993 (1993-01), page 580, XP000431799 ISSN: 0160-4619

## Description

### FIELD OF THE INVENTION

This invention relates to methods and alkaline-containing photoresist stripping and cleaning compositions for cleaning microelectronics substrates, and particularly such compositions useful with and compatible with metal electrode stacks used in the flat panel display (FPD) markets. The compositions of this invention provide enhanced protection of metal, i.e., inhibition of corrosion, when such microelectronic substrates are subjected to an aqueous rinse.

### BACKGROUD TO THE INVENTION

Many photoresist strippers and residue removers have been proposed for use in the microelectronics field as downstream or back end of the manufacturing line cleaners, in the manufacturing process a thin film of photoresist is deposited on a substrate material, and then circuit design is imaged on the thin film. Following baking, the exposed resist is removed with a photoresist developer. The resulting image is then transferred to the underlying material, which is generally a dielectric or metal, by way of plasma etch gases or chemical etchant solutions. The etchant gases or chemical etchant solutions selectively attack the photoresist-unprotected area of the substrate. As a result of the plasma etching process, photoresist and etched material by-products are deposited as residues around or on the sidewall of the etched openings on the substrate and the photoresist.

Additionally, following the termination of the etching step, the resist mask must be removed from the protected area of the substrate so that the next process operation can take place. This can be accomplished in a plasma ashing step by the use of suitable plasma ashing gases or wet chemical strippers. Finding a suitable cleaning composition for removal of this resist mask material without adversely affecting, e.g., corroding, etching or dulling, the metal circuitry has also proven problematic.

As microelectronic fabrication integration levels have increased and patterned microelectronic device dimensions have decreased, it has become increasing difficult to provide suitable photoresist stripping and cleaning compositions that provide suitable stripping and cleaning properties without producing other detrimental effects. In the area of flat panel display (FPD) applications, particularly with the use of select metals and alloys, the problem of metal corrosion during photoresist stripping and the water rinse is a severe drawback.

Due to issues with electrical performance and reliability in mass production, a variety of metal stacks are utilized for forming gate lines in FPD technology. Multiple metal layers such as Mo/AlNd/Mo, and especially double layers such as Mo/AlNd, AlNd/Ti, and AlNd/Cr are common for gate line metal stacks in current manufacturing of FPD technologies. However, in stacks where the AlNd alloy is located beneath another metal, aluminum corrosion during the rinse step can be a critical problem for electrical performance. This corrosion is commonly known as overhang and can create voids that weaken the metal structure. Loss of aluminum to corrosion during the chemical cleaning or water rinse steps can also create notching in the metal lines, which is the most common defect at FPD technology. The composition of the cleaning solution and its behavior in water plays a key role in causing corrosion A typical photoresist remover for FPD applications might include polar organic solvents blended with organic amines and other solvating agents. Amines have been shown to increase the effectiveness of photoresist removal in solvent blends. However, the water rinse following this type of remover can create a strongly alkaline aqueous solution and that can lead to considerable loss of metal from the patterned lines. EP-A-0 596 515 shows such an amine containing resist-stripping solution. This necessitates an intermediate rinse between the cleaning/stripping step and the aqueous rinse. Such an intermediate rinse, typically with isopropyl alcohol, adds undesirable time, safety concems, environmental consequences, and cost to the manufacturing process.

There is therefore a need for an alkaline-containing stripping and cleaning compositions for photoresists that enable one to completely remove photoresists and etch and/or ash residue from the microelectronic substrate yet not produce any significant metal corrosion during a subsequent aqueous rinse step, especially for FPD microelectronic elements.

### SUMMARY OF THE INVENTION

The invention provides alkaline-containing cleaning compositions for cleaning microelectronic substrates, particularly FPD microelectronic substrates, that are able to essentially completely clean such substrates and produce essentially no metal corrosion of the metal elements of such substrates. The invention also provides method of using such alkaline-containing cleaning compositions to clean microelectronic substrates, particularly FPD microelectronic substrates, without producing any significant metal corrosion of the metal elements of the microelectronic substrate. The alkaline-containing cleaning compositions of this invention comprise (a) a nucleophilic amine, (b) a moderate to weak acid having a strength expressed as a "pKa" for the dissociation constant in aqueous solution of from about 1.2 to about 8, preferably from about 1.3 to about 6, and more preferably from about 2.0 to about 6, and most preferably of from about 2 to about 5 (c) a compound selected from an aliphatic alcohol, diol, polyol or aliphatic glycol ether, and (d) an organic co-solvent preferably having a solubility parameter of from about 8 to about 15, obtained by taking the square root off the sum of the three Hansen solubility parameters (dispersive, polar and hydrogen bonding). The cleaning compositions of this invention will have an amount of weak acid such that the equivalent mole ratio of acid groups to amine groups is greater than .75 and may range up to and beyond a ratio of 1, such as for example a ratio of 1.02 or more. The pH of the alkaline-containing cleaning compositions of this invention will be from about pH 4.5 to 9.5, preferably from about pH 6.5 to 9.5 and most preferably from about pH 8.5 to 9.5.

The cleaning compositions of this invention can be used to clean any suitable microelectronic substrate, and are especially useful to clean FPD microelectronic substrate elements and are able to do so without causing any significant metal corrosion in a subsequent aqueous wash step of the microelectronic substrate. The cleaning compositions of this invention are particularly suitable for cleaning FPD microelectronic substrates containing aluminum, and especially those containing aluminum/neodymium components without causing any significant metal corrosion in a subsequent aqueous wash step of the microelectronic substrate.

### DETAILED DESCRIPTION OF THE INVENTION AND PREFERRED EMBODIMENTS

The alkaline-containing cleaning compositions of this invention contain a nucleophilic amine. Any suitable nucleophilic amine can be employed in the compositions of this invention. Examples of suitable nucleophilic amines include, but are not limited to, 1-amino-2-propanol, 2-(2-aminoethoxy)ethanol, 2-aminoethanol, 2-(2-aminoethylamino)ethanol, 2-(2-aminoethylamino)ethylamine, diethanolamine, triethanolamine, and the like. The nucleophilicity of the amine component should be high. The amount of the nucleophilic amine component employed in the cleaning composition of this invention will generally be from about 1% to about 50%, preferably from about 10% to about 45%, and especially from about 12% to about 25%, based on the total weight of the cleaning composition.

The alkaline-containing cleaning compositions of this invention contain an aliphatic alcohol, diol, polyol or aliphatic glycol ether component. The aliphatic component of the is preferably an alkyl or alkylene moiety containing from about 2 to about 20 carbon atoms, preferably from about 2 to about 10 carbon atoms, and most preferably from about 2 to about 6 carbon atoms. Any suitable aliphatic alcohol, diol, polyol or aliphatic glycol ether can be employed ion the compositions of this invention. Examples of such suitable compounds include, but are not limited to, isopropanol, butanal, ethylene glycol, diethylene glycol, triethylene glycol, polyethylene glycol, propylene glycol, dipropylene glycol, tripropylene glycol, 1,3-propanediol, 2-methyl-1.3-propanediol, butanediols and butenediols, such as 2-butene-1,4-diol, pentanediols such as 2-methyl-2,4-pentanediol, hexanediols, glycerol, ethylene glycol monomethyl ether diethylene glycol monomethyl ether, propylene glycol dimethyl ether, 2-(2-butxyethoxy)-ethanol and the like. Particularly preferred are alkane diols of from 2 to 6 carbon atoms and especially ethylene glycol and propylene glycol. The amount of aliphatic alcohol, diol, polyol or aliphatic glycol ether component in the cleaning compositions of this invention will generally be from about 10% to about 80%, preferably from about 20% to about 60%, and especially from about 25% to about 40%, based on the total weight of the cleaning composition.

The alkaline-containing cleaning compositions of this invention will have present any suitable organic co-solvent component, preferably an organic co-solvent having a solubility parameter of from about 8 to about 15. The co-solvent may be any one or more suitable co-solvents. Such suitable co-salvants include, but are not limited to, 2-pyrrolidinone, 1-methyl-2-pyrrolidinone, 1-ethyl-2-pyrrolidinone, 1-propyl-2-pyrrolidinone, 1-hydroxyethyl-2-pyrrolidinone, sulfur oxides such as dialkyl sulfones, dimethyl sulfoxide, tetrahydrothipphene-1-,1-dioxide compounds such as sulfolane, methyl sulfolane, athylsulfolane, dimethylacetamide and dimethylformamide and the like. The amount of co-solvent component in the cleaning compositions of this invention will generally be from about 20% to about 80%, preferably from about 25% to about 70%, and especially from about 30% to about 45%, based on the total weight of the cleaning composition.

The alkaline-containing cleaning compositions of this invention have present a component comprising any suitable moderately strong to weak acid having a strength expressed as a "pKa" for the dissociation constant in aqueous solution of from about 1.2 to about 8, preferably from about 1.3 to about 6, and more preferably from about 2.0 to about 5 Such acids can be organic or inorganic acids. Example of such suitable weak acids include, but are not limited to, carboxylic acids such as acetic acid, propanoic acid, malonic acid, phthalic acic, phenoxyacetic acid, mercaptobenzoic acid, 2-mercatptoethanol and the like, and inorganic acids such as carbonic acid, hydrofluoric acid, hypophosphorus acid and the like. The amount of weak acid employed in the composition will generally be in an amount such that the equivalent mole ratio of acid moieties to amine moieties is greater than 0.75, preferably from greater than 0.75 to about 1.6 and most preferably from about 0.76 to about 1.0. When present in the foregoing amounts the acid component will generally comprise from about 1% to about 50%, preferably from about 10% to about 35%, and most preferably from about 12% to about 25%, by weight of the total components in the composition.

The alkaline-containing cleaning compositions of this invention can also optionally contain other components, including but not limited to, corrosion inhibitors, non-corrosive surfactants and similar non-corrosive components employed in alkaline-containing microelectronic cleaner compositions.

The compositions on this invention, their use to clean microelectronic substrates, especially FPD microelectronic substrates and their non-metal corroding properties is illustrated by, but not limited to, the following examples.

The following test procedure was employed in the following examples. Test samples consisted of a glass substrate and a metal electrode composed of a molybdenum layer on an aluminum/neodymium (Al/Nd) (∼97% Al) layer. Both layers were applied by sputtering and patterned by photolithography as follows: 1) 1.5µm of a positive photoresist was applied by spin coating, 2) the coated resist was soft baked at about 80° C, 3) then the photorest coated substrate was exposed for patterning, 4) the exposed, patterned substrate was then developed for 60 seconds, followed by 5) hard baking at over 140° C for three minutes. The metals are then etched in a multi-step process such that there is no overhang of the molybdenum layer.

Samples were prepared by cleaving the glass substrate sheet into pieces about 1-2 cm². These samples were cleaned by suspension in a test solution at conditions described hereinafter in a small stirred bath. For tests of cleaning efficiency, samples were next rinsed in flowing deionized water for one minute. To better simulate corrosion in rinse water, samples cleaned at 70° C for three minutes, were placed directly in a 5 % solution of the same cleaning material composition in deionized water at 30° C for 5 minutes. No formulations tested cause corrosion of the molybdenum layer, so only corrosion of Al/Nd is indicated. The water rinse pH was also determined from a 5% solution concentration of the cleaning compositions. Drying with N₂ immediately followed either rinse step. Sample cleanliness and corrosion were determined by scanning electron microscope analysis.

In the examples below, the following terms are used:
For "cleaning": "Clean" represents complete removal of all resist and "Incomplete" indicates any amount of bulk resist not removed from the metals.
For "Corrosion": "None" indicates no loss of Al/Nd line material, "Slight" indicated loss of fine edges of Al/Nd lines at the substrate interface, and "Some" indicates limited corrosion of the bulk Al/Nd line.
"Molecular weight ratio" means the ratio of the molecular weight of the acid component to the amine component multiplied by the ratio of number of acid groups in the acid component to the number of amine groups in the amine component.

### EXAMPLES

Example 1: An initial solution comprised of N-methylpyrrolidinone (about 44%), ethylene glycol (about 33%), and monoethanolamine (about 22%) was prepared. To this solution was added glacial acetic acid to produce the test solutions indicated below.

| Composition (amount of acid) | Equivalent mole ratio acid/amine | pH 5% sol. | Cleaning (3 min. 70° C) | Al/Nd corrosion (5% sol. 30° C) |
|---|---|---|---|---|
| 14.3% acetic acid | 0.765 | 9.4 | Clean | None |
| 15.1% acetic acid | 0.82 | 9.29 | Clean | None |
| 16.1% acetic acid | 0.88 | 9.06 | Clean | None |
| 17.1% acetic acid | 0.94 | 8.65 | Clean | None |
| 17.9% acetic acid | 1 | 6.63 | Clean | None |
| 18.1% acetic acid | 1.02 | 6.34 | Clean | None |

Example 2: An initial solution comprised of N-methylpyrrolidinone (about 44%), ethylene glycol (about 33%), and monoethanolamine (about 22%) was prepared. To this solution was added the acids indicated below.

| Composition-edded acid | Equivalent mole ratio acid/amine | pH 5% sol. | Cleaning (3 min. 70° C) | Al/Nd corrosion (5% sol. 30° C) |
|---|---|---|---|---|
| 13.8% hypophosphorous acid | 0.8 | 9.21 | Clean | None |
| 22.5% maloric acid | 0.8 | 4.77 | Clean | Some |

Example 3: Solutions were prepared with compositions of N-methylpyrrolidinone (37%), monoethanolamine (19%), glacial acetic acid (15%), and the remaining component (29%) as indicated below.

| Added component | Equivalemt mole ratio acid/amine | pH 5% sol. | Cleaning (3 min. 70° C | Al/Nd corrosion (5% sol. 30° C) |
|---|---|---|---|---|
| propylene glycol | 0.8 | 9.39 | Clean | Some |
| 2-methyl-2,4-pentanediol | 0.8 | 9.37 | Clean | None |
| glycerol | 0.8 | 9.38 | Clean | None |
| 2-butene-1,4-diol | 0.8 | 9.37 | Clean | Slight |
| Isopropanol | 0.8 | 8.9 | Clean | None |
| 2-(2-butoxyethoxy)-ethanol | 0.8 | 9.12 | Clean | None |

Example 4: Solutions were prepared with compositions of monoethanolamine (19%), glacial acetic acid (14.3%), and the remaining percentage comprising N-methylpyrrolidinone (NMP) and ethylene glycol (EG) indicated.

| Composition %NMP/%EG | Equivalent mole ratio acid/amine | pH 5% sol. | Cleaning (3 min. 70° C) | Cleaning (30 sec. 70° C) | Al/Nd corrosion (5% sol. 30° C) |
|---|---|---|---|---|---|
| 100%/0% | 0.765 | 9.24 | Clean | Redeposit | None |
| 57%/43% | 0.765 | 9.4 | Clean | Clean | None |
| 43%/53% | 0.765 | 9.41 | Clean | Clean | Slight |
| 0%/100% | 0.765 | 9.43 | Clean | Redeposit | Some |

Comparative Example A: A solution comprising N-methylpyrrolidinone (47%), ethylene glycol (35.3%), and glacial acetic acid (17.7%) was prepared.

| Composition | Equivalent mole ratio acid/amine | pH 5% sol. | Cleaning (3 min. 70° C) | Al/Nd corrosion (5% sol. 30° C) |
|---|---|---|---|---|
| No Amine | N/A | 2.48 | Incomplete | None |

Comparative Example B: This example was conducted by the same procedure as Example 1, except a solution comprising N-methylpyrrolidinone (30%), monoethanolamine (10%), and 2-(2-Butoxyethoxy)ethanol (17%) was prepared. The exposure temperature was 70° C and the exposure time was three minutes. These conditions yielded a complete dean. A five-minute, 5% solution rinse showed complete corrosion of the visible Al/Nd layer such that the molybdenum overlayer was undercut considerably.

While the invention has been described herein with reference to the specific embodiments thereof, it will be appreciated that changes, modification and variations can be made without departing from the invention in the appended claims.

## Claims

1. A non-aqueous composition for cleaning microelectronic substrates comprising the following components;
(a) a nucleophilic amine,
(b) a moderate to weak acid having a strength expressed as a "pKa" for the dissociation constant in aqueous solution of from about 1.2 to about 8,
(c) a compound selected from the group consisting of an aliphatic alcohol, diol, polyol or glycol ether, and
(d) an organic co-solvent,
and the acid component (b) is present in the composition in an amount such that the equivalent mole ratio of acid/amine is greater than .75 and the pH of the composition is from about pH 4.5 to 9.5, with the proviso that the composition does not have the following compositions:
13.4 wt% glycerine, 14.8 wt% of the polyethylene glycol PEG400, 203 wt% monopropylene glycol, 15 wt% citric acid, 25 wt% of the acrylic acid homopolymer ACUSOL, WE and 11.5 wt% monoethanol amine.

2. A composition according to claim 1 comprising from about 1% to about 50% component (a), from about 10% to about 80% of component (c), and from about 20% to about 80% component (d), the percentages being weight % based on the total weight of the composition.

3. A composition according to claim 1 wherein the nucleophilic amine component is at least one amine selected from the group consisting of 1-amino-2-propanol, 2-(2aminoethoxy)ethanol, 2-aminoethanol, 2-(2-aminoethylamino)ethanol, 2-(2-aminoethylamino)ethylamine, diethanolamine and triethanolamine.

4. A composition according to claim 1 wherein component (c) Is at least one compound selected from the group consisting of isopropanol, butanol, ethylene glycol, diethylene glycol, triethylene glycol, polyethylene glycol, propylene glycol, dipropylene glycol, tripropylene glycol, 1,3-propanediol, 2-methyl-1,3-propanediol, 2-butene-1,4-diol, 2-methyl-2,4-pentanediol, hexanediol, glycerol, ethylene glycol monomethyl ether, diethylene glycol monomethyl ether, propylene glycol dimethyl ether, and 2-(2-butoxyethoxy)-ethanol.

5. A composition according to claim 1 wherein the organic co-solvent is a co-solvent having a solubility parameter of from about 8 to about 16.

6. A composition according to claim 5 wherein the organic co-solvent is at least one compound selected from the group consisting of 2-pyrrolidinone, 1-methyl-2-pyrrolidinon, 1-ethyl-2-pyrrolidinone, 1-propyl-2-pyrrolidinone, 1-hydroxyethyl-2-pyrrolidinone, a dialkyl sulfone, dimethyl sulfoxide, a tetrahydrothiophene-1-,1-dioxide, dimethylacetamide and dimethylformamide.

7. A composition according to claim 6 wherein the organic co-solvent is selected from the group consisting of sulfolane and 1-methyl-2-pyrrolidinone, the nucleophilic amine is selected from the group consisting of monoethanolamine and 1-amino-2-propanol, component (c) is selected from the group consisting of ethylene glycol, propylene glycol, 2-methyl-2,4-pentanediol, glycerol, 2-butene-1,4-diol, isopropanol and 2-(2-butoxyethoxy)ethanol.

8. A composition according to claim 1 wherein the acid component (b) is at least one acid having a pKa value of from 2 to 5.

9. A composition according to claim 7 wherein the add component (b) Is at least one acid having a pKa value of from 2 to 5.

10. A composition according to claim 1 wherein component (b) comprises at least one acid selected from the group consisting of acetic acid, propanoic acid, malonic acid, phenylacetic add and hypophosphorus acid.

11. A composition according to claim 7 wherein component (b) comprises at least one acid selected from the group consisting of acetic acid, propanoic acid, malonic acd, phenylacetic acid and hypophosphorus acid.

12. A composition according to claim 1 wherein the nucleophilic amine comprises monoethanolamine, the co-solvent comprises 1-methyl-2-pyrrolidinone, the compound of component (c) is ethylene glycol and the add of component (b) Is acetic acid.

13. A process for cleaning a microelectronic substrate without producing any substantial metal corrosion, the substrate containing photoresist polymeric material and a metal, the process comprising contacting the substrate with a non-aqueous cleaning composition for a time sufficient to clean the substrate, wherein the cleaning composition comprises;
(a) a nucleophilic amine,
(b) a moderate to weak add having a strength expressed as a "pKa" for the dissociation constant In aqueous solution of from about 1.2 to about 8,
(c) a compound selected from the group consisting of an aliphatic alcohol, diol, polyol or glycol ether, and
(d) an organic co-solvent,
and the acid component (b) Is present In the cleaning composition In an amount such that the equivalent mole ratio of acid/amino Is greater than .75 and the pH of the composition Is from about pH 4.5 to 9.6.

14. A process according to claim 13 wherein the cleaning composition comprises from about 1% to about 50% component (a), from about 10% to about 80% of component (c), and from about 20% to about 80% component (d), the percentages being weight % based on the total weight the composition.

15. A process according to claim 13 wherein the nucleophilic amine component is at least one amine selected from the group consisting of 1-amino-2-propanol, 2-(2-aminoethoxy)ethanol, 2-aminoethanol, 2-(2-aminoethylamino)ethanol, 2-(2-aminoethylamino)ethylamine, diethanolamine and triethenolamine.

16. A process according to claim 13 wherein component (c) Is at least one compound selected from the group consisting of isopropanol, butanol, ethylene glycol, diethylene glycol, triethylene glycol, polyethylene glycol, propylene glycol, dipropylene glycol, tripropylene glycol, 1,3-propanediol, 2-methyl-1,3-propanediol, 2-butene-1,4-diol, 2-methyl-2,4-pentanediol, hexanediol, glycerol, ethylene glycol monomethyl ether diethylene glycol monomethyl ether, propylene glycol dimethyl ether, and 2-(2-butoxyethoxy)-ethanol.

17. A process according to claim 13 wherein the organic co-solvent is a co-solvent having a solubility parameter of from about 8 to about 15.

18. A process according to claim 17 wherein the organic co-solvent is at least one compound selected from the group consisting of 2-pyrrolidinone, 1-methyl-2-pyrrolidinone, 1-ethyl-2-pyrrolidinone, 1-propyl-2-pyrrolidinone, 1-hydroxyethyl-2-pyrrolidinone, a dialkyl sulfone, dimethyl sulfoxide, a tetrahydrothiophene-1-,1-dioxide, dimethylacetamide and dimethylformamide.

19. A process according to claim 18 wherein the organic co-solvent is selected from the group consisting of sulfolane and 1-methyl-2-pyrrolidinone, the nucleophilic amine is selected from the group consisting of monoethanolamine and 1-amino-2-propanol, component (c) is selected from the group consisting of ethylene glycol, propylene glycol, 2-methyl-2,4-pentanediol, glycerol, 2-butene-1,4-diol, isopropanol and 2-(2-butoxyethoxy)ethanol.

20. A process according to claim 13 wherein the acid component (b) Is at least one add having a pKa value of from 2 to 5.

21. A process according to claim 19 wherein the acid component (b) is at least one acid having a pKa value of from 2 to 5.

22. A process according to claim 13 wherein component (b) comprises at least one acid selected from the group consisting of acetic acid, propanoic acid, malonic add, phenylacetic acid and hypophosphorus acid.

23. A process according to claim 19 wherein component (b) comprises at least one add selected from the group consisting of acetic acid, propanoic acid, malonic acd, phenylacetic acid and hypophosphorus acid.

24. A process according to claim 13 wherein the nucleophilic amine comprises monoethanolamine, the co-solvent comprises 1-methyl-2-pyrrolidinone, the compound of component (e) is ethylene glycol and the acid of component (b) is acetic acid.

25. A process according to claim 13 wherein the microelectronic substrate is a substrate for a flat panel display.

26. A process according to claim 25 wherein the substrate has an aluminum/neodymium layer.

## Patentansprüche

1. Nicht-wässrige Zusammensetzung zur Reinigung von mikroelektronischen Substraten, die die folgenden Komponenten umfasst;
(a) ein nukleophiles Amin,
(b) eine moderate bis schwache Säure, die eine Stärke, ausgedrückt als ein "pKa" für die Dissoziationskonstante in wässriger Lösung, von etwa 1,2 bis etwa 8 hat,
(c) eine Verbindung, ausgewählt aus der Gruppe, bestehend aus einem aliphatischen Alkohol, Diol, Polyol oder Glycolether, und
(d) ein organisches Co-Lösungsmittel,
und die Säurekomponente (b) liegt in der Zusammensetzung in so einer Menge vor, dass das äquivalente Molverhältnis von Säure/Amin größer als 0,75 ist und der pH der Zusammensetzung von etwa pH 4,5 bis 9,5 ist, mit der Maßgabe, dass die Zusammensetzung nicht die folgende Zusammensetzung hat:
13,4 Gew.-% Glycerin, 14,8 Gew.-% des Polyethylenglycols PEG400, 20,3 Gew.-% Monopropylenglycol, 15 Gew.-% Citronensäure, 25 Gew.-% des Acrylsäurehomopolymers ACUSOL WE und 11,5 Gew.-% Monoethanolamin.

2. Zusammensetzung gemäß Anspruch 1, die von etwa 1% bis etwa 50% der Komponente (a), von etwa 10% bis etwa 80% der Komponente (c) und von etwa 20% bis etwa 80% der Komponente (d) umfasst, wobei die Prozentwerte Gew.-% basierend auf dem Gesamtgewicht der Zusammensetzung sind.

3. Zusammensetzung gemäß Anspruch 1, wobei die nukleophiles Amin-Komponente mindestens ein Amin, ausgewählt aus der Gruppe, bestehend aus 1-Amino-2-propanol, 2-(2-Aminoethoxy)-ethanol, 2-Aminoethanol, 2-(2-Aminoethylamino)ethanol, 2-(2-Aminoethylamino)ethylamin, Diethanolamin und Triethanolamin, ist.

4. Zusammensetzung gemäß Anspruch 1, wobei die Komponente (c) mindestens eine Verbindung, ausgewählt aus der Gruppe, bestehend aus Isopropanol, Butanol, Ethylenglycol, Diethylenglycol, Triethylenglycol, Polyethylenglycol, Propylenglycol, Dipropylenglycol, Tripropylenglycol, 1,3-Propandiol, 2-Methyl-1,3-propandiol, 2-Buten-1,4-diol, 2-Methyl-2,4-pentandiol, Hexandiol, Glycerol, Ethylenglycolmonomethylether, Diethylenglycolmonomethylether, Propylenglycoldimethylether und 2-(2-Butoxyethoxy)ethanol, ist.

5. Zusammensetzung gemäß Anspruch 1, wobei das organische Co-Lösungsmittel ein Co-Lösungsmittel ist, das einen Löslichkeitsparameter von etwa 8 bis etwa 15 hat.

6. Zusammensetzung gemäß Anspruch 5, wobei das organische Co-Lösungsmittel mindestens eine Verbindung, ausgewählt aus der Gruppe, bestehend aus 2-Pyrrolidinon, 1-Methyl-2-pyrrolidinon, 1-Ethyl-2-pyrrolidinon, 1-Propyl-2-pyrrolidinon, 1-Hydroxyethyl-2-pyrrolidinon, einem Dialkylsulfon, Dimethylsulfoxid, einem Tetrahydrothiophen-1,1-dioxid, Dimethylacetamid und Dimethylformamid, ist.

7. Zusammensetzung gemäß Anspruch 6, wobei das organische Co-Lösungsmittel ausgewählt ist aus der Gruppe, bestehend aus Sulfolan und 1-Methyl-2-pyrrolidinon, das nukleophile Amin ausgewählt ist aus der Gruppe, bestehend aus Monoethanolamin und 1-Amino-2-propanol, die Komponente (c) ausgewählt ist aus der Gruppe, bestehend aus Ethylenglycol, Propylenglycol, 2-Methyl-2,4-pentandiol, Glycerol, 2-Buten-1,4-diol, Isopropanol und 2-(2-Butoxyethoxy)ethanol.

8. Zusammensetzung gemäß Anspruch 1, wobei die Säurekomponente (b) mindestens eine Säure, die einen pKa-Wert von 2 bis 5 hat, ist.

9. Zusammensetzung gemäß Anspruch 7, wobei die Säurekomponente (b) mindestens eine Säure, die einen pKa-Wert von 2 bis 5 hat, ist.

10. Zusammensetzung gemäß Anspruch 1, wobei die Komponente (b) mindestens eine Säure, ausgewählt aus der Gruppe, bestehend aus Essigsäure, Propionsäure, Malonsäure, Phenylessigsäure und hypophosphoriger Säure, umfasst.

11. Zusammensetzung gemäß Anspruch 7, wobei die Komponente (b) mindestens eine Säure, ausgewählt aus der Gruppe, bestehend aus Essigsäure, Propionsäure, Malonsäure, Phenylessigsäure und hypophosphoriger Säure, umfasst.

12. Zusammensetzung gemäß Anspruch 1, wobei das nukleophile Amin Monoethanolamin umfasst, das Co-Lösungsmittel 1-Methyl-2-pyrrolidinon umfasst, die Verbindung der Komponente (c) Ethylenglycol ist und die Säure der Komponente (b) Essigsäure ist.

13. Verfahren zur Reinigung eines mikroelektronischen Substrats ohne eine wesentliche Metallkorrosion zu erzeugen, wobei das Substrat ein Photoresistpolymermaterial und ein Metall umfasst, wobei das Verfahren Inkontaktbringen des Substrats mit einer nicht-wässrigen Reinigungszusammensetzung für eine Zeit, die ausreichend ist, um das Substrat zu reinigen, umfasst, wobei die Reinigungszusammensetzung umfasst;
(a) ein nukleophiles Amin,
(b) eine moderate bis schwache Säure, die eine Stärke, ausgedrückt als ein "pKa" für die Dissoziationskonstante in wässriger Lösung, von etwa 1,2 bis etwa 8 hat,
(c) eine Verbindung, ausgewählt aus der Gruppe, bestehend aus einem aliphatischen Alkohol, Diol, Polyol oder Glycolether, und
(d) ein organisches Co-Lösungsmittel,
und die Säurekomponente (b) liegt in der Zusammensetzung in so einer Menge vor, dass das äquivalente Molverhältnis von Säure/Amin größer als 0,75 ist und der pH der Zusammensetzung von etwa pH 4,5 bis 9,5 ist,

14. Verfahren gemäß Anspruch 13, wobei die Reinigungszusammensetzung von etwa 1% bis etwa 50% der Komponente (a), von etwa 10% bis etwa 80% der Komponente (c) und von etwa 20% bis etwa 80% der Komponente (d) umfasst, wobei die Prozentwerte Gewichtsprozent basierend auf dem Gesamtgewicht der Zusammensetzung sind.

15. Verfahren gemäß Anspruch 13, wobei die nukleophiles Amin-Komponente mindestens ein Amin, ausgewählt aus der Gruppe, bestehend aus 1-Amino-2-propanol, 2-(2-Aminoethoxy)ethanol, 2-Aminoethanol, 2-(2-Aminoethylamino)ethanol, 2-(2-Aminoethylamino)ethylamin, Diethanolamin und Triethanolamin, ist.

16. Verfahren gemäß Anspruch 13, wobei die Komponente (c) mindestens eine Verbindung, ausgewählt aus der Gruppe, bestehend aus Isopropanol, Butanol, Ethylenglycol, Diethylenglycol, Triethylenglycol, Polyethylenglycol, Propylenglycol, Dipropylenglycol, Tripropylenglycol, 1,3-Propandiol, 2-Methyl-1,3-propandiol, 2-Buten-1,4-diol, 2-Methyl-2,4-pentandiol, Hexandiol, Glycerol, Ethylenglycolmonomethylether, Diethylenglycolmonomethylether, Propylenglycoldimethylether und 2-(2-Butoxyethoxy)ethanol, ist.

17. Verfahren gemäß Anspruch 13, wobei das organische Co-Lösungsmittel ein Co-Lösungsmittel ist, das einen Löslichkeitsparameter von etwa 8 bis etwa 15 hat.

18. Verfahren gemäß Anspruch 17, wobei das organische Co-Lösungsmittel mindestens eine Verbindung, ausgewählt aus der Gruppe, bestehend aus 2-Pyrrolidinon, 1-Methyl-2-pyrrolidinon, 1-Ethyl-2-pyrrolidinon, 1-Propyl-2-pyrrolidinon, 1-Hydroxyethyl-2-pyrrolidinon, einem Dialkylsulfon, Dimethylsulfoxid, einem Tetrahydrothiophen-1,1-dioxid, Dimethylacetamid und Dimethylformamid, ist.

19. Verfahren gemäß Anspruch 18, wobei das organische Co-Lösungsmittel ausgewählt ist aus der Gruppe, bestehend aus Sulfolan und 1-Methyl-2-pyrrolidinon, das nukleophile Amin ausgewählt ist aus der Gruppe, bestehend aus Monoethanolamin und 1-Amino-2-propanol, die Komponente (c) ausgewählt ist aus der Gruppe, bestehend aus Ethylenglycol, Propylenglycol, 2-Methyl-2,4-pentandiol, Glycerol, 2-Buten-1,4-diol, Isopropanol und 2-(2-Butoxyethoxy)ethanol.

20. Verfahren gemäß Anspruch 13, wobei die Säurekomponente (b) mindestens eine Säure, die einen pKa-Wert von 2 bis 5 hat, ist.

21. Verfahren gemäß Anspruch 19, wobei die Säurekomponente (b) mindestens eine Säure, die einen pKa-Wert von 2 bis 5 hat, ist.

22. Verfahren gemäß Anspruch 13, wobei die Komponente (b) mindestens eine Säure, ausgewählt aus der Gruppe, bestehend aus Essigsäure, Propionsäure, Malonsäure, Phenylessigsäure und hypophosphoriger Säure, umfasst.

23. Verfahren gemäß Anspruch 19, wobei die Komponente (b) mindestens eine Säure, ausgewählt aus der Gruppe, bestehend aus Essigsäure, Propionsäure, Malonsäure, Phenylessigsäure und hypophosphoriger Säure, umfasst.

24. Verfahren gemäß Anspruch 13, wobei das nukleophile Amin Monoethanolamin umfasst, das Co-Lösungsmittel 1-Methyl-2-pyrrolidinon umfasst, die Verbindung der Komponente (c) Ethylenglycol ist und die Säure der Komponente (b) Essigsäure ist.

25. Verfahren gemäß Anspruch 13, wobei das mikroelektronische Substrat ein Substrat für einen Flachbildschirm ist.

26. Verfahren gemäß Anspruch 25, wobei das Substrat eine Aluminium/Neodym-Schicht hat.

## Revendications

1. Composition non aqueuse destinée au nettoyage de substrats microélectroniques comprenant les composants suivants ;
(a) une amine nucléophile,
(b) un acide modéré à faible ayant une force exprimée par un « pKa » pour la constante de dissociation en solution aqueuse d'environ 1,2 à environ 8,
(c) un composé choisi dans le groupe constitué d'un alcool aliphatique, d'un diol, d'un polyol ou d'un glycol éther, et
(d) un co-solvant organique,
et le composant acide (b) est présent dans la composition en une quantité telle que le rapport molaire équivalent acide/amine est supérieur à 0,75 et le pH de la composition est d'environ 4,5 à 9,5, à condition que la composition ne présente pas la composition suivante :
13,14 % en poids de glycérine, 14,8 % en poids du polyéthylène glycol PEG400, 20,3 % en poids de monopropylène glycol, 15 % en poids d'acide citrique, 25 % en poids de l'homopolymère d'acide acrylique ACUSOL WE et 11,5 % en poids de monoéthanolamine.

2. Composition selon la revendication 1 comprenant d'environ 1 % à environ 50 % de composant (a), d'environ 10 % à environ 80 % de composant (c), et d'environ 20 % à environ 80 % de composant (d), les pourcentages étant en % en poids par rapport au poids total de la composition.

3. Composition selon la revendication 1 dans laquelle le composant amine nucléophile est au moins une amine choisie dans le groupe constitué du 1-amino-2-propanol, du 2-(2-aminoéthoxy)éthanol, du 2-aminoéthanol, du 2-(2-aminoéthylamino)éthanol, de la 2-(2-aminoéthylamino)éthylamine, de la diéthanolamine et de la triéthanolamine.

4. Composition selon la revendication 1 dans laquelle le composant (c) est au moins un composé choisi dans le groupe constitué de l'isopropanol, du butanol, de l'éthylène glycol, du diéthylène glycol, du triéthylène glycol, du polyéthylène glycol, du propylène glycol, du dipropylène glycol, du tripropylène glycol, du 1,3-propanediol, du 2-méthyl-1,3-propanediol, du 2-butène-1,4-diol, du 2-méthyl-2,4-pentanediol, de l'hexanediol, du glycérol, de l'éther monométhylique d'éthylène glycol, de l'éther monométhylique de diéthylène glycol, de l'éther diméthylique de propylène glycol et du 2-(2-butoxyéthoxy)-éthanol.

5. Composition selon la revendication 1 dans laquelle le co-solvant organique est un co-solvant ayant un paramètre de solubilité d'environ 8 à environ 15.

6. Composition selon la revendication 5 dans laquelle le co-solvant organique est au moins un composé choisi dans le groupe constitué de la 2-pyrrolidinone, de la 1-méthyl-2-pyrrolidinone, de la 1-éthyl-2-pyrrolidinone, de la 1-propyl-2-pyrrolidinone, de la 1-hydroxyéthyl-2-pyrrolidinone, d'une dialkylsulfone, du sulfoxyde de diméthyle, d'un tétrahydrothiophène-1-,1-dioxyde, du diméthylacétamide et du diméthylformamide.

7. Composition selon la revendication 6 dans laquelle le co-solvant organique est choisi dans le groupe constitué du sulfolane et de la 1-méthyl-2-pyrrolidinone, l'amine nucléophile est choisie dans le groupe constitué de la monoéthanolamine et du 1-amino-2-propanol, le composant (c) est choisi dans le groupe constitué de l'éthylène glycol, du propylène glycol, du 2-méthyl-2,4-pentanediol, du glycérol, du 2-butène-1,4-diol, de l'isopropanol et du 2-(2-butoxyéthoxy)éthanol.

8. Composition selon la revendication 1 dans laquelle le composant acide (b) est au moins un acide ayant une valeur pKa de 2 à 5.

9. Composition selon la revendication 7 dans laquelle le composant acide (b) est au moins un acide ayant une valeur pKa de 2 à 5.

10. Composition selon la revendication 1 dans laquelle le composant (b) comprend au moins un acide choisi dans le groupe constitué de l'acide acétique, de l'acide propanoïque, de l'acide malonique, de l'acide phénylacétique et de l'acide hypophosphoreux.

11. Composition selon la revendication 7 dans laquelle le composant (b) comprend au moins un acide choisi dans le groupe constitué de l'acide acétique, de l'acide propanoïque, de l'acide malonique, de l'acide phénylacétique et de l'acide hypophosphoreux.

12. Composition selon la revendication 1 dans laquelle l'amine nucléophile comprend de la monoéthanolamine, le co-solvant comprend de la 1-méthyl-2-pyrrolidinone, le composé du composant (c) est l'éthylène glycol et l'acide du composant (b) est l'acide acétique.

13. Procédé de nettoyage d'un substrat microélectronique sans production d'une quelconque corrosion métallique substantielle, le substrat contenant un matériau polymère photorésistant et un métal, le procédé comprenant la mise en contact du substrat avec une composition de nettoyage non aqueuse pendant une durée suffisante pour nettoyer le substrat, dans lequel la composition de nettoyage comprend ;
(a) une amine nucléophile,
(b) un acide modéré à faible ayant une force exprimée par un « pKa » pour la constante de dissociation en solution aqueuse d'environ 1,2 à environ 8,
(c) un composé choisi dans le groupe constitué d'un alcool aliphatique, d'un diol, d'un polyol ou d'un glycol éther, et
(d) un co-solvant organique,
et le composant acide (b) est présent dans la composition de nettoyage en une quantité telle que le rapport molaire équivalent acide/amine est supérieur à 0,75 et le pH de la composition est d'environ pH 4,5 à 9,6.

14. Procédé selon la revendication 13 dans lequel la composition de nettoyage comprend d'environ 1 % à environ 50 % de composant (a), d'environ 10 % à environ 80 % de composant (c), et d'environ 20 % à environ 80 % de composant (d), les pourcentages étant en % en poids par rapport au poids total de la composition.

15. Procédé selon la revendication 13 dans lequel le composant amine nucléophile est au moins une amine choisie dans le groupe constitué du 1-amino-2-propanol, du 2-(2-aminoéthoxy)éthanol, du 2-aminoéthanol, du 2-(2-aminoéthylamino)éthanol, de la 2-(2-aminoéthylamino)éthylamine, de la diéthanolamine et de la triéthanolamine.

16. Procédé selon la revendication 13 dans lequel le composant (c) est au moins un composé choisi dans le groupe constitué de l'isopropanol, du butanol, de l'éthylène glycol, du diéthylène glycol, du triéthylène glycol, du polyéthylène glycol, du propylène glycol, du dipropylène glycol, du tripropylène glycol, du 1,3-propanediol, du 2-méthyl-1,3-propanediol, du 2-butène-1,4-diol, du 2-méthyl-2,4-pentanediol, de l'hexanediol, du glycérol, de l'éther monométhylique d'éthylène glycol, de l'éther monométhylique de diéthylène glycol, de l'éther diméthylique de propylène glycol et du 2-(2-butoxyéthoxy)-éthanol.

17. Procédé selon la revendication 13 dans lequel le co-solvant organique est un co-solvant ayant un paramètre de solubilité d'environ 8 à environ 15.

18. Procédé selon la revendication 17 dans lequel le co-solvant organique est au moins un composé choisi dans le groupe constitué de la 2-pyrrolidinone, de la 1-méthyl-2-pyrrolidinone, de la 1-éthyl-2-pyrrolidinone, de la 1-propyl-2-pyrrolidinone, de la 1-hydroxyéthyl-2-pyrrolidinone, d'une dialkylsulfone, du sulfoxyde de diméthyle, d'un tétrahydrothiophène-1-,1-dioxyde, du diméthylacétemide et du diméthylformamide.

19. Procédé selon la revendication 18 dans lequel le co-solvant organique est choisi dans le groupe constitué du sulfolane et de la 1-méthyl-2-pyrrolidinone, l'amine nucléophile est choisie dans le groupe constitué de la monoéthanolamine et du 1-amino-2-propanol, le composant (c) est choisi dans le groupe constitué de l'éthylène glycol, du propylène glycol, du 2-méthyl-2,4-pentanediol, du glycérol, du 2-butène-1,4-diol, de l'isopropanol et du 2-(2-butoxyéthoxy)éthanol.

20. Procédé selon la revendication 13 dans lequel le composant acide (b) est au moins un acide ayant une valeur pKa de 2 à 5.

21. Procédé selon la revendication 19 dans lequel le composant acide (b) est au moins un acide ayant une valeur pKa de 2 à 5.

22. Procédé selon la revendication 13 dans lequel le composant (b) comprend au moins un acide choisi dans le groupe constitué de l'acide acétique, de l'acide propanoïque, de l'acide malonique, de l'acide phénylacétique et de l'acide hypophosphoreux.

23. Procédé selon la revendication 19 dans lequel le composant (b) comprend au moins un acide choisi dans le groupe constitué de l'acide acétique, de l'acide propanoïque, de l'acide malonique, de l'acide phénylacétique et de l'acide hypophosphoreux.

24. Procédé selon la revendication 13 dans lequel l'amine nucléophile comprend de la monoéthanolamine, le co-solvant comprend de la 1-méthyl-2-pyrrolidinone, le composé du composant (c) est l'éthylène glycol et l'acide du composant (b) est l'acide acétique.

25. Procédé selon la revendication 13 dans lequel le substrat microélectronique est un substrat pour un écran plat.

26. Procédé selon la revendication 25 dans lequel le substrat comporte une couche d'aluminium/néodyme.
